# EUROPEAN PATENT SPECIFICATION

(11) **EP 2 071 549 B1**
(45) Date of publication and mention of the grant of the patent: **10.05.2017**
(21) Application number: 08253652.5
(22) Date of filing: 07.11.2008
(51) Int. Cl.: G09G 3/32, H01L 21/77

(54) **Display device**
Anzeigevorrichtung
Dispositif d'affichage

(30) Priority: 08.11.2007 KR 20070113658
(43) Date of publication of application: 17.06.2009
(73) Proprietor: Samsung Display Co., Ltd., Gyeonggi-do (KR)
(72) Inventor: Kim, Hyung-Soo, Suwon-si Gyeonggi-do (KR); Kim, Ki-Wook, Suwon-si Gyeonggi-do (KR)
(74) Representative: Mounteney, Simon James

(56) References cited:
- WO-A-94/20949
- US-A1- 2003 090 452
- US-A1- 2006 012 550
- US-A1- 2006 017 681
- US-A1- 2007 252 153
- US-B1- 6 982 451

## Description

### BACKGROUND OF THE INVENTION

### 1. Field of the Invention

Embodiments relate to a display device and a method of fabricating the same, in which the display device is configured to reduce or eliminate distortion of a control signal transmitted to pixels.

### 2. Description of the Related Art

As display devices are made larger and with higher resolutions, it may be necessary to increase the length and/or reduce the with of wires used to transmit signals in a display panel of the display device. Further, as the wires become more heavily loaded, the signals carried on the wires may be delayed and/or distorted. For example, control signals, such as a scan signal for selectively supplying a data signal to pixels and/or a light-emission control signal for selectively allowing the pixels to emit light, may be distorted. As a result, the display device may not operate properly. Additionally, the long wires in the display panel may produce an antenna effect, which may cause the deterioration of panel characteristics and/or the reduction of manufacturing yields due to substrate damage. Accordingly, there is a need for advances in the art of display devices that enable the formation of large and/or high revolution panels.

WO9420949 discloses a polysilicon gate bus structure used for activating a row of pixels in a matrix of pixels of an active matrix liquid crystal display. The polysilicon gate bus is formed with a plurality of buffers interspersed along its length. A plurality of field effect transistors, each associated with one pixel in a row of pixels, have their gate electrodes connected to the polysilicon gate bus with the buffers interspersed among the gate electrode connections so as to speed up a row scanning signal propagation time to e each of the gate electrode connections.

### SUMMARY OF THE INVENTION

Embodiments are therefore directed to a display device and a method of fabricating the same, which substantially overcome one or more of the problems due to the limitations and disadvantages of the related art.

It is therefore a feature of an embodiment to provide a display device, and a method of fabricating the same, having buffer circuits in a display panel.

It is therefore another feature of an embodiment to provide a display device, and a method of fabricating the same, having control lines formed of dissimilar conductive materials.

At least one of the above and other features and advantages may be realized by providing a display device according to claim 1.

The buffer circuit may include first and second inverters, the control line may include a first portion coupled to an input terminal of the first inverter and a second portion coupled to an output terminal of the second inverter.

The first portion of the control line and the input terminal of the first inverter may be in a first layer of the buffer circuit, and the second portion of the control line and the output terminal of the second inverter may be in a second layer of the buffer circuit, the second layer being different from the first layer. The first layer may be below the second layer.

Gate electrodes of transistors in the first inverter may be formed of the first conductive material, and source/drain electrodes of transistors in the second inverter may be formed of the second conductive material. A portion of the control line may be formed of a same material as a gate electrode of a transistor in the pixel.

The first and second inverters may each have transistors of different conductivity types coupled in series between a first power source and a second power source, the first and second inverters being coupled to each other, the first portion of the control line may be coupled to gate electrodes of transistors in the first inverter, the second portion of the control line may be coupled to source/drain electrodes of transistors in the second inverter, and the first and second portions of the control line may be electrically coupled by the buffer circuit.

The pixel unit may include a first power line configured to supply the first power source to the buffer circuits, the pixel unit may include a second power line configured to supply the second power source to the buffer circuits, and a layout pattern of the first power lines may alternate with a layout pattern of the second power lines. The pixel unit may include a first power line configured to supply a first power source to the buffer circuits, the pixel unit may include a second power line configured to supply a second power source to the buffer circuits, and the first and second power lines may be disposed in a mesh in the pixel unit.

The display device may further include at least one driver coupled to the control lines, the pixel unit may be on a display substrate, and the driver may be on a driver substrate that is separate from the display substrate. The display substrate may be transparent to visible light.

At least one of the above and other features and advantages may also be realized by providing a method of fabricating a display device, including forming a pixel unit including at least one pixel having a control line coupled thereto, the control line being configured to supply a control signal to the pixel, a data line configured to supply a data signal to the pixel, and at least one buffer circuit disposed in the pixel unit and coupled to the control line, coupling at least one driver to the pixel unit, the driver configured to provide a control signal to the control line, and coupling at least one power source to the pixel unit, the power source configured to provide power to the buffer circuit.

### BRIEF DESCRIPTION OF THE DRAWINGS

The above and other features and advantages will become more apparent to those of ordinary skill in the art by describing in detail example embodiments with reference to the attached drawings, in which:
FIG. 1 illustrates a schematic view of a display device according to a first example embodiment;
FIG. 2 illustrates a buffer circuit in a pixel unit of the display device illustrated in FIG. 1;
FIG. 3 illustrates a cross-sectional view of the buffer circuit illustrated in FIG. 2;
FIG. 4 illustrates a plan view of an arrangement of buffer circuits in a pixel unit according to a second example embodiment;
FIG. 5 illustrates a plan view of an arrangement of buffer circuits in a pixel unit according to a third example embodiment;
FIG. 6 illustrates a plan view of an arrangement of buffer circuits in a pixel unit according to a fourth example embodiment; and

### DETAILED DESCRIPTION OF THE INVENTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the invention to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

As used herein, the expressions "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C" and "A, B, and/or C" includes the following meanings: A alone; B alone; C alone; both A and B together; both A and C together; both B and C together; and all three of A, B, and C together. Further, these expressions are open-ended, unless expressly designated to the contrary by their combination with the term "consisting of." For example, the expression "at least one of A, B, and C" may also include an n^{th} member, where n is greater than 3, whereas the expression "at least one selected from the group consisting of A, B, and C" does not.

As used herein, the expression "or" is not an "exclusive or" unless it is used in conjunction with the term "either." For example, the expression "A, B, or C" includes A alone; B alone; C alone; both A and B together; both A and C together; both B and C together; and all three of A, B and, C together, whereas the expression "either A, B, or C" means one of A alone, B alone, and C alone, and does not mean any of both A and B together; both A and C together; both B and C together; and all three of A, B and C together.

As used herein, the terms "a" and "an" are open terms that may be used in conjunction with singular items or with plural items. For example, the term "a metal" may represent a single compound, e.g., tungsten, or multiple compounds in combination, e.g., tungsten mixed with chromium.

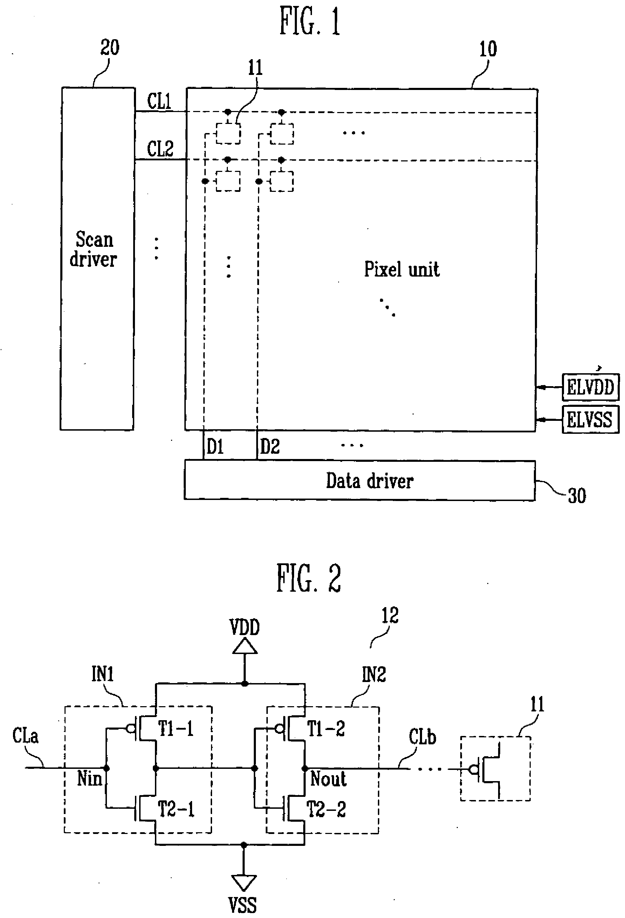

FIG. 1 illustrates a schematic view of a display device according to a first example embodiment.

Referring to FIG. 1, the display device may be, e.g., an organic light emitting display device, and may include a pixel unit 10 having a plurality of light emitting elements, e.g., organic light emitting diodes (OLEDs).

The pixel unit 10 is formed on a display substrate, e.g., a substrate that is transparent to visible light, and includes a plurality of pixels 11 disposed at the intersections of control lines (CL) and data lines (D). The control lines (CL) may be disposed between the pixels 11, and may extend in a first direction (a horizontal or row direction) to supply a control signal to the pixels 11. The control lines (CL) may include, e.g., scan lines and/or light-emission control lines. The data lines (D) may be disposed between the pixels 11, and may extend in a second direction (a vertical or column direction) that intersects the first direction to supply a data signal to the pixels 11.

The pixel unit 10 may display an image corresponding to a control signal supplied from the control lines (CL), a data signal supplied from the data lines (D), and first and second pixel power sources ELVDD and ELVSS, respectively, which may be externally supplied.

The organic light emitting display device of this embodiment further includes a scan driver 20 and a data driver 30 coupled to and driving the pixel unit 10. The scan driver 20 and the data driver 30 may be formed on respective driver substrates. The scan driver 20 may generate a control signal, e.g., a scan signal and/or a light-emission control signal, for controlling the pixels 11 to correspond to an externally supplied scan driver control signal. The scan driver 20 may then supply the generated control signal to one or more of the control lines (CL).

The data driver 30 may generate a data signal to correspond to externally supplied data and a data control signals. The data driver 30 may then supply the generated data signal to the data lines (D).

In the organic light emitting display device, the control lines (CL) and data lines (D) controlling the pixels 11 may be arranged over the entire region of the pixel unit 10 in a row direction and a column direction, respectively. If the organic light emitting display device is manufactured with a large scale or with a high resolution, wires of the control lines (CL) for supplying a control signal to the pixels 11 may increase in length and/or decrease in width. In this case, the control lines (CL) may become heavily loaded, and thus a control signal transmitted on the control lines (CL) may be delayed. As a result, a distorted control signal may be supplied to some of the pixels 11, particularly the pixels 11 disposed at the greatest distance from the drive circuit, e.g., the scan driver 20, that supplies the control signal. Such distorted control signals may cause the organic light emitting display device to operate improperly.

In order to reduce or avoid problems arising from distorted control signals, one or more buffer circuits 12 (see FIG. 2) may be implemented for each of the control lines (CL) disposed in the pixel unit 10 to compensate for the delay of the control signals. The buffer circuits 12 may be formed by the row, and may be disposed to compensate for a delayed control signal passing through the control lines (CL). The buffer circuits 12 may be disposed between the pixels 11 and may be formed in the pixel unit 10.

FIG. 2 illustrates a buffer circuit 12 in the pixel unit 10 of the display device illustrated in FIG. 1 according to an embodiment of the invention.

Referring to FIG. 2, the buffer circuit 12 includes first and second inverters (IN1 and IN2) coupled together between a first power source (VDD) and a second power source (VSS). The first power source (VDD) and the second power source (VSS) may be drive power sources for the buffer circuits 12. The voltages of the first and second power sources VDD, VSS may be set to the voltages of the drive power sources of the scan driver 20, or to the voltages of other drive power sources, etc.

The first inverter (IN1) is coupled to an input terminal via an input node Nin of the buffer circuit 12, and the second inverter (IN2) is coupled to an output terminal of the buffer circuit 12 via an output node Nout. In an implementation, a plurality of inverters (not shown) may be further provided between the first inverter (IN1) and the second inverter (IN2). The inverters are preferably disposed in pairs.

Each of the inverters (IN1 and IN2) may include transistors (T) of different conductivity types, which may be coupled in series between the drive power sources, e.g., between the first power source (VDD) and the second power source (VSS). For example, a P-type first transistor (T1) may be coupled to the first power source (VDD), and an N-type second transistor (T2) may be coupled to the second power source (VSS).

Each of the control lines (CL) may have first and second portions (CLa) and (CLb) coupled via the corresponding buffer circuit 12 in a region the buffer circuits 12 are disposed. Thus, the first and second portions (CLa and CLb) of the control lines (CL) may be electrically coupled via the buffer circuit 12.

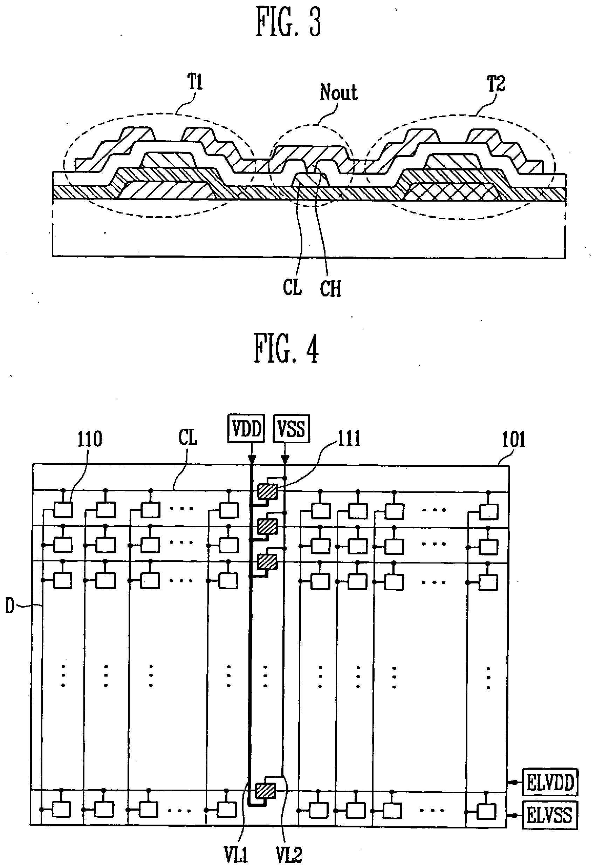

FIG. 3 illustrates a cross-sectional view of the buffer circuit illustrated in FIG. 2.

Referring to FIGS. 2 and 3, the first and second portions (CLa and CLb) of the control lines (CL) are physically separated at the buffer circuit 12, with an end portion of the first portion (CLa) being coupled to the input terminal of the first inverter (IN1), and an end portion of the second portion (CLb) being coupled to the output terminal of the second inverter (IN2). The first and second portions (CLa and CLb) of the control lines (CL) may be formed of dissimilar conductive materials.

An input terminal of the buffer circuit 12, i.e., an input terminal of the first inverter (IN1), is coupled to gate electrodes (G) of first and second transistors (T1-1 and T2-1) of the first inverter (IN1). Accordingly, the first portion (CLa) of the control line (CL) and the input terminal of the buffer circuit 12 may be formed of the same conductive material and in the same layer, and may be formed at the same time. For example, the first portion (CLa) of the control line (CL) may be formed of gate electrode metal used for the gate electrodes (G) of the first and second transistors (T1-1 and T2-1) of the first inverter IN1.

The output terminal of the buffer circuit 12, i.e., the output terminal of the second inverter (IN2), is connected to source/drain electrodes of the first and second transistors (T1-2 and T2-2) of the second inverter (IN2). An output node (Nout) of the buffer circuit may be formed by the electrical coupling of the control line (CL) and the output terminal. In an implementation, the output terminal of the buffer circuit 12 may be formed of different conductive materials and in a different layer from the control line (CLa) and the input terminal of the buffer circuit 12. For example, the output terminal of the buffer circuit 12 may be formed of a same metal used for source and drain electrodes, and may be in a different layer from the control lines (CLa) and the input terminal of the buffer circuit. The second portion (CLb) of the control line (CL) may be formed of the same material used for the source/drain electrodes of the transistors (T1-2 and T2-2) of the second inverter (IN2).

As shown in FIG. 2, each control line (CL) may be coupled to a control electrode of a switching element formed in a pixel 11, e.g., the control line (CL) may be coupled to a gate electrode of a pixel transistor in the pixel 11. In an implementation, the portion of the control line (CL) coupled to the gate electrode of the pixel transistor may be formed of the same material as the gate electrode of the pixel transistor.

Each of the control lines (CL) may be electrically coupled through the buffer circuit. For example, a predetermined portion of the control line CL coupled to the output terminal of the second inverter (IN2) maybe formed of the source/drain material, and a predetermined portion of the control line (CL) coupled to the gate electrode of the pixel transistor may be formed of the gate material.

The first and second portions (CLa and CLb) of the control lines (CL) may be joined where the buffer circuits 12 are inserted in the control lines (CL). The input terminal and the output terminal of the buffer circuit 12 may be formed of different conductive materials, which may be arranged in different layers.

The material of the control line (CL) may be changed from the source/drain material to the gate material in a predetermined point, e.g., between the end portion of the control line (CL) coupled to the output terminal of the second inverter (IN2) and the end portion of the control line (CL) coupled to the gate electrode of the pixel transistor, through a contact hole (CH), as shown in FIG. 3.

Accordingly, when a control signal supplied to each of the control lines (CL) is provided to the buffer circuit 12 on the first portion (CLa) of the control line (CL) and re-transmitted on the second portion (CLb) of the control line (CL) via the buffer circuit 12, the control signal is transmitted to the control line (CL) via wires formed of at least two different conductive materials. The use of different conductive materials may reduce or prevent an antenna effect, which may be important during fabrication and/or operation of the display device.

FIG. 4 illustrates a plan view of an arrangement of buffer circuits in a pixel unit according to a second example embodiment.

Referring to FIG. 4, buffer circuits 111 are disposed in a pixel unit 101 corresponding to rows of respective control lines (CL). The buffer circuits 111 may be the same as the buffer circuits 12 according to the first example embodiment described above. The pixel unit includes pixels 110 driven by the control lines (CL). The pixels 110 may be the same as the pixels 11 according to the first example embodiment described above, and may be supplied with data via data lines (D).

One buffer circuit 111 may be provided for each control line (CL). The buffer circuits 111 in the pixel unit 101 may be disposed to form one column in the center of the pixel unit 101.

The buffer circuits 111 may receive externally-supplied drive power sources, e.g., the first and second power sources (VDD and VSS). To provide power from the first and second power sources (VDD and VSS), respective first and second power lines (VL1 and VL2) may be disposed in the pixel unit 101. The first power line (VL1) may supply the first power source (VDD) to the buffer circuits 111, and the second power line (VL2) may supply the second power source (VSS) to the buffer circuits 111. In an implementation, the first power line (VL1) and the second power line (VL2) may be formed to extend in a column direction on opposite sides of the buffer circuits 111, in the case that the buffer circuits 111 are arranged in the column direction.

By inserting the buffer circuits 111 into the respective control lines (CL) to correct a waveform of the control signal supplied from the left or right side, a distorted signal may be prevented from being transmitted to the pixels 110. Also, the relatively simple arrangement of the buffer circuits 111 facilitates the design of the organic light emitting diode.

The first power line (VL1) and the second power line (VL2) are illustrated with different thicknesses in FIG. 4, 5 and 6. This is done merely to distinguish the first and second power lines (VL1 and VL2), and is not meant to limit the present invention to power lines of different thicknesses.

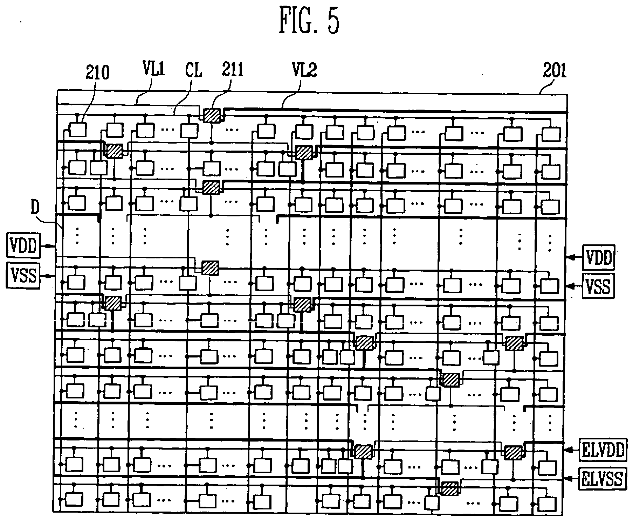

FIG. 5 illustrates a plan view of an arrangement of buffer circuits in a pixel unit according to a third example embodiment.

Referring to FIG. 5, buffer circuits 211 are disposed in predetermined regions of a pixel unit 201. For example, the buffer circuits 211 may be disposed in an upper left region and a lower right region of the pixel unit 201. That is, the buffer circuits 211 may be implemented only in the upper left and lower right regions of the pixel unit 201. In the regions of the pixel unit 201 containing the buffer circuits 211, the buffer circuits 211 may be arranged in a zig-zag manner. For example, the buffer circuits 211 may be disposed in a zig-zag manner in the upper left region, and may be disposed in a zig-zag manner in a lower right region.

Further, the predetermined regions of the pixel unit 201 that include the buffer circuits 211 may themselves be arranged in a zig-zag manner, or may be arranged in diagonal direction across the pixel unit 201. Distances between the buffer circuits 211 may be set using simulation, etc.

The first power line (VL1) for supplying the first power source (VDD) and the second power line (VL2) for supplying the second power source (VSS) may be formed inside the pixel unit 201, since the buffer circuits 211 may be driven by the first and second power sources (VDD and VSS) from the outside. The first and second power lines (VL1 and VL2) may extend in a row direction above the pixels 210 that are driven by the corresponding buffer circuits 211. The power lines (VL) of a same type in adjacent rows may be disposed to be coupled to each other. The first and second power lines (VL1 and VL2) may receive first and second power sources (VDD and VSS) from both sides of the pixel unit 201, and may transmit the first and second power sources (VDD and VSS) to corresponding buffer circuits 211 coupled to the first and second power lines (VL1 and VL2).

According to the third example embodiment, it may be possible to reduce or prevent the transmission of a distorted control signal by inserting the buffer circuits 211 into respective control lines (CL). Buffer circuits 211 in continuous rows may not be disposed in one column, and instead may be distributed throughout the pixel unit 201. Accordingly, the buffer circuits 211 may be prevented from appearing as a dark line on the display device. Thus, according to the third example embodiment, it may be possible to prevent not only the distortion of a control signal supplied through the control lines (CL), but also the deterioration of image quality.

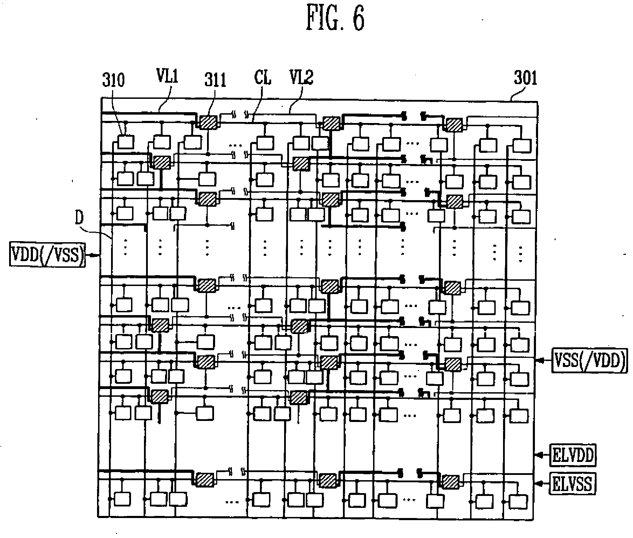

FIG. 6 illustrates a plan view of an arrangement of buffer circuits in a pixel unit according to a fourth example embodiment.

Referring to FIG. 6, buffer circuits 311 may be disposed at regular intervals in each of control lines (CL), e.g., in a checkerboard pattern. Further, the buffer circuits 311 may be distributed so that they are not disposed in one column.

The first power line (VL1) for supplying the first power source (VDD) and the second power line (VL2) for supplying the second power source (VSS) may be formed inside the pixel unit 301. The first and second power lines (VL1 and VL2) may extend in a row direction and may be disposed above pixels 310 of corresponding buffer circuits 311.

Layout regions of first and second power lines (VL1 and VL2) may alternate. For example, as shown in FIG. 6, a first column-shaped layout region in the left-most portion of the pixel unit 310 may include first power lines VL1, a second column-shaped layout region directly adjacent to the first layout region may include second power lines VL2, a third column-shaped layout region directly adjacent to the second layout region may include first power lines VL1, etc., such that the power lines (VL) are formed in respective alternating column-shaped regions. In another implementation, the first and second power lines (VL1 and VL2) may be disposed in a mesh. The first and second power lines (VL1 and VL2) may receive first and second power sources (VDD and VSS) from one side or both sides of the pixel unit 301, and may transmit the first and second power sources (VDD and VSS) to the buffer circuits 311 that are coupled to the first and second power lines (VL1 and VL2).

According to the above-described fourth example embodiment, the buffer circuits 311 may be inserted into respective control lines (CL) to prevent a distorted signal from being transmitted to the pixels 310. In particular, a plurality of the buffer circuits 311 may be inserted into the respective control lines (CL) and spaced apart at regular intervals, so that it may be possible to effectively correct a control signal delayed via the control lines (CL). Therefore, the control signal may be transmitted to any pixel 310 in the pixel unit 301 with little or no distortion. Consequently, it may be possible to effectively prevent poor driving caused by the distortion of a control signal.

Also, the buffer circuits 211 in directly adjacent rows may not be disposed in a same column, but instead may be distributed throughout the pixel unit 201. Accordingly the buffer circuits 211 may be prevented from appearing as a dark line when an image is displayed. Thus, according to the fourth example embodiment, it may be possible to prevent not only the distortion of a control signal supplied through the control lines (CL), but also the deterioration of image quality. In addition, because the buffer circuits 311 according to the fourth example embodiment may be arranged in a predetermined repeating pattern, the layout of buffer circuits 311 may be expanded as required by the size of the pixel unit 301. Accordingly, it may be possible to compensate the distortion of a control signal uniformly throughout the pixel unit 301, while easily scaling the layout for a large-sized panel.

FIGS. 4 to 6 show that the buffer circuits 111, 211, and 311 are not overlapped with the pixels 110, 210, and 310. However, the present invention is not limited thereto, and at least a portion of the buffer circuits 111, 211, and 311 may be overlapped with the pixels 110, 210, 310. For example, if the pixels 110, 210, 310 each include an organic light emitting diode (OLED) and a pixel circuit for driving the organic light emitting diode (OLED), the buffer circuits 111, 211, 311 may be disposed between the pixel circuits of the adjacent pixels 110, 210, 310 on both their sides so as not to overlap with the pixel circuits. However, at least a portion of the organic light emitting diode (OLED) formed in an upper layer, above the pixel circuit, may overlap with at least a portion of the buffer circuits 111, 211, 311.

In detail, a switching transistor, a driving transistor, and a capacitor that form a pixel circuit may be shifted by a predetermined distance so as not to overlap with the buffer circuits 111, 211, 311 in a region in which the buffer circuits 111, 211, 311 are disposed. Also, such a shift of the pixel circuits may not be limited to those pixels 110, 210, 310 that are adjacent to the buffer circuits 111, 211, 311. For example, all of the pixel circuits may be shifted uniformly throughout the pixel units 101, 201, 301 on the basis of the buffer circuits 111, 211, 311. However, the organic light emitting diodes (OLEDs) may be disposed to maintain their positions, without being shifted, as compared to when the buffer circuits 111, 211, 311 are not formed. In this case, a portion of the organic light emitting diodes (OLED) of pixels 110, 210, 310 disposed on both sides of the buffer circuits 111, 211, 311 may be disposed to overlap with a portion of the buffer circuits 111, 211, 311. When the pixel units 101, 201, 301 are top emitting, i.e., emit light in a direction opposite to the pixel circuits, a region in which the buffer circuit 111, 211, 311 are formed may not appear as a dark point or a dark line. Thus, the buffer circuit 111, 211, 311 may be placed in the pixel units 101, 201, 301 so as to partially overlap with organic light emitting diodes (OLED) of adjacent pixels 110, 210 310, thereby preventing the deterioration of image quality.

As described above, an organic light emitting display device according to embodiments may compensate a control signal, which may be delayed while passing through the control lines, using buffer circuits inserted into each of the control lines arranged in the pixel unit. Therefore, poor driving of pixels may be reduced or prevented by avoiding application of a distorted control signal to each of the pixels. Each of the control lines may maintain electrical coupling over the entire panel through the buffer circuits, and an input terminal and an output terminal of the buffer circuit may be formed of different conductive materials disposed in different layers. Accordingly, while a control signal supplied to each of the control lines is re-transmitted to the control lines via the buffer circuits, the control signal may be re-transmitted to the control lines via control wires formed of at least two different conductive materials. The different conductive materials may prevent an antenna effect. In addition, the organic light emitting display device may avoid deterioration of image quality by placing the buffer circuits in predetermined layouts across the pixel unit. These features may be used to implement a display device having a digital drive mode, and having pixels with a relatively simple configuration.

Example embodiments have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope as set forth in the following claims.

## Claims

1. A display device, comprising a pixel unit (10), the pixel unit (10) including:
a drive circuit configured to generate control signals, the control signals comprising scan and/or emission control signals;
a plurality of pixels (11) formed in rows and columns and having control lines coupled thereto, the control lines being disposed in rows and configured to supply the control signals to rows of the pixels;
a plurality of data lines configured to supply data signals to the pixels; and
a plurality of buffer circuits (12) disposed in the pixel unit (10) each coupled to an intermediate portion of a said control line, wherein each buffer circuit is coupled between a first power source and a second power source which are set to the voltages of drive power sources of the drive circuit and the buffer circuit is configured to compensate for a delay of the control signal, and wherein the buffer circuits (12) are disposed in a checkerboard pattern, such that buffer circuits (12) in a same row are spaced apart by at least one column of pixels, and buffer circuits (12) in a same column are spaced apart by at least one row of pixels;
wherein the control line includes a first portion comprising a first wire formed of a first conductive material, and a second portion comprising a second wire formed of a second conductive material that is different from the first conductive material, the first portion being coupled to the second portion by the buffer circuit (12).

2. A display device according to claim 1, wherein:
each buffer circuit (12) includes first and second inverters, and the first portion of the control line is coupled to an input terminal of the first inverter and the second portion is coupled to an output terminal of the second inverter.

3. A display device according to claim 2, wherein the first portion of the control line and the input terminal of the first inverter are in a first layer of the buffer circuit, and the second portion of the control line and the output terminal of the second inverter are in a second layer of the buffer circuit (12), the second layer being different from the first layer.

4. A display device according to claim 3, wherein the first layer is below the second layer.

5. A display device according to any one of claims 2 to 4, wherein:
gate electrodes of transistors in the first inverter are formed of the first conductive material, and source/drain electrodes of transistors in the second inverter are formed of the second conductive material.

6. A display device according to claim 5, wherein a portion of the control line is formed of a same material as a gate electrode of a transistor in the pixel.

7. A display device according to claim 2, wherein:
the first and second inverters each have transistors of different conductivity types coupled in series between a first power source and a second power source, the first and second inverters being coupled to each other, the first portion of the control line is coupled to gate electrodes of transistors in the first inverter;
the second portion of the control line is coupled to source/drain electrodes of transistors in the second inverter; and
the first and second portions of the control line are electrically coupled by the buffer circuit (12).

8. A display device according to any one of the preceding claims, wherein:
the pixel unit (10) includes a first power line configured to supply the first power source to the buffer circuits (12);
the pixel unit (10) includes a second power line configured to supply the second power source to the buffer circuits (12); and
the arrangement of the first and second power lines is such that a layout pattern of the first power lines alternates with a layout pattern of the second power lines or the arrangement of the first and second power lines is such that the first and second power lines are disposed in a mesh in the pixel unit (10).

## Patentansprüche

1. Anzeigevorrichtung, umfassend eine Bildpunkteinheit (10), wobei die Bildpunkteinheit (10) einschließt:
eine Treiberschaltung, die dafür konfiguriert ist, Steuersignale zu erzeugen, wobei die Steuersignale Raster- und/oder Emissionssteuersignale umfassen;
eine Vielzahl von Bildpunkten (11), die in Zeilen und Spalten ausgebildet sind und damit gekoppelte Steuerleitungen haben, wobei die Steuerleitungen in Zeilen angeordnet und dafür konfiguriert sind, die Steuersignale an Zeilen der Bildpunkte anzulegen;
eine Vielzahl von Datenleitungen, die dafür konfiguriert sind, Datensignale an die Bildpunkte anzulegen; und
eine in der Bildpunkteinheit (10) angeordnete Vielzahl von Pufferschaltungen (12), deren jede mit einem Zwischenabschnitt einer Steuerleitung gekoppelt ist, worin jede Pufferschaltung zwischen eine erste Leistungsquelle und eine zweite Leistungsquelle gekoppelt ist, die auf die Spannungen der Treiberleistungsquellen der Treiberschaltung eingestellt sind, und die Pufferschaltung dafür konfiguriert ist, eine Verzögerung des Steuersignals auszugleichen, und worin die Pufferschaltungen (12) in einem Schachbrettmuster angeordnet sind, sodass Pufferschaltungen (12) in einer gleichen Zeile um mindestens eine Spalte von Bildpunkten voneinander entfernt sind und Pufferschaltungen (12) in einer gleichen Spalte um mindestens eine Zeile von Bildpunkten voneinander entfernt sind; worin
die Steuerleitung einen ersten Abschnitt, der einen aus einem ersten leitfähigen Material gebildeten ersten Draht einschließt, und einen zweiten Abschnitt, der einen aus einem zweiten leitfähigen Material, das sich vom ersten leitfähigen Material unterscheidet, gebildeten zweiten Draht umfasst, aufweist, wobei der erste Abschnitt durch die Pufferschaltung (12) mit dem zweiten Abschnitt gekoppelt ist.

2. Anzeigevorrichtung nach Anspruch 1, worin:
jede Pufferschaltung (12) einen ersten und zweiten Inverter einschließt und der erste Abschnitt der Steuerleitung mit einem Eingangsanschluss des ersten Inverters gekoppelt ist und der zweite Abschnitt mit einem Ausgangsanschluss des zweiten Inverters gekoppelt ist.

3. Anzeigevorrichtung nach Anspruch 2, worin der erste Abschnitt der Steuerleitung und der Eingangsanschluss des ersten Inverters in einer ersten Schicht der Pufferschaltung liegen und der zweite Abschnitt der Steuerleitung und der Ausgangsanschluss des zweiten Inverters in einer zweiten Schicht der Pufferschaltung (12) liegen, wobei sich die zweite Schicht von der ersten Schicht unterscheidet.

4. Anzeigevorrichtung nach Anspruch 3, worin die erste Schicht unterhalb der zweiten Schicht liegt.

5. Anzeigevorrichtung nach einem der Ansprüche 2 bis 4, worin:
Gate-Elektroden von Transistoren im ersten Inverter aus dem ersten leitfähigen Material gebildet sind und Source/Drain-Elektroden von Transistoren im zweiten Inverter aus dem zweiten leitfähigen Material gebildet sind.

6. Anzeigevorrichtung nach Anspruch 5, worin ein Abschnitt der Steuerleitung aus einem gleichen Material wie eine Gate-Elektrode eines Transistors in dem Bildpunkt gebildet ist.

7. Anzeigevorrichtung nach Anspruch 2, worin:
der erste und zweite Inverter jeweils Transistoren unterschiedlicher Leitfähigkeitstypen haben, die zwischen einer ersten Leistungsquelle und einer zweiten Leistungsquelle in Reihe geschaltet sind, wobei der erste und zweite Inverter miteinander gekoppelt sind, wobei der erste Abschnitt der Steuerleitung mit Gate-Elektroden von Transistoren im ersten Inverter gekoppelt ist;
der zweite Abschnitt der Steuerleitung mit Source/Drain-Elektroden von Transistoren im zweiten Inverter gekoppelt ist; und
der erste und zweite Abschnitt der Steuerleitung durch die Pufferschaltung (12) elektrisch gekoppelt sind.

8. Anzeigevorrichtung nach einem der vorhergehenden Ansprüche, worin:
die Bildpunkteinheit (10) eine erste Leistungsleitung einschließt, die dafür konfiguriert ist, die erste Leistungsquelle mit den Pufferschaltungen (12) zu koppeln;
die Bildpunkteinheit (10) eine zweite Leistungsleitung einschließt, die dafür konfiguriert ist, die zweite Leistungsquelle mit den Pufferschaltungen (12) zu koppeln; und
die Anordnung der ersten und zweiten Leistungsleitungen derart ist, dass eine Layoutstruktur der ersten Leistungsleitungen sich mit einer Layoutstruktur der zweiten Leistungsleitungen abwechselt, oder die Anordnung der ersten und zweiten Leistungsleitungen derart ist, dass die ersten und zweiten Leistungsleitungen in der Bildpunkteinheit (10) in Maschen angeordnet sind.

## Revendications

1. Dispositif d'affichage, comprenant une unité de pixels (10), ladite unité de pixels (10) incluant :
un circuit de pilotage qui est configuré de manière à générer des signaux de commande, les signaux de commande comprenant des signaux de commande de balayage et/ou d'émission ;
une pluralité de pixels (11) qui sont formés selon des rangées et des colonnes et qui comportent des lignes de commande qui leur sont couplées, les lignes de commande étant disposées selon des rangées et étant configurées de manière à appliquer les signaux de commande sur des rangées des pixels ;
une pluralité de lignes de données qui sont configurées de manière à appliquer des signaux de données sur les pixels ; et
une pluralité de circuits tampon (12) qui sont disposés dans l'unité de pixels (10) et dont chacun est couplé à une section intermédiaire d'une dite ligne de commande, dans lequel chaque circuit tampon est couplé entre une première source de puissance et une seconde source de puissance qui sont réglées aux tensions de sources de puissance de pilotage du circuit de pilotage, et le circuit tampon est configuré de manière à compenser un retard du signal de commande, et dans lequel les circuits tampon (12) sont disposés selon un motif en échiquier de telle sorte que des circuits tampon (12) dans une même rangée soient espacés par au moins une colonne de pixels et que des circuits tampon (12) dans une même colonne soient espacés par au moins une rangée de pixels ; dans lequel :
la ligne de commande inclut une première section qui comprend un premier fil qui est formé à partir d'un premier matériau conducteur et une seconde section qui comprend un second fil qui est formé à partir d'un second matériau conducteur qui est différent du premier matériau conducteur, la première section étant couplée à la seconde section au moyen du circuit tampon (12).

2. Dispositif d'affichage selon la revendication 1, dans lequel :
chaque circuit tampon (12) inclut des premier et second inverseurs, et la première section de la ligne de commande est couplée à une borne d'entrée du premier inverseur et la seconde section est couplée à une borne de sortie du second inverseur.

3. Dispositif d'affichage selon la revendication 2, dans lequel la première section de la ligne de commande et la borne d'entrée du premier inverseur sont dans une première couche du circuit tampon, et la seconde section de la ligne de commande et la borne de sortie du second inverseur sont dans une seconde couche du circuit tampon (12), la seconde couche étant différente de la première couche.

4. Dispositif d'affichage selon la revendication 3, dans lequel la première couche est au-dessous de la seconde couche.

5. Dispositif d'affichage selon l'une quelconque des revendications 2 à 4, dans lequel :
des électrodes de grille de transistors dans le premier inverseur sont formées à partir du premier matériau conducteur et des électrodes de source/drain de transistors dans le second inverseur sont formées à partir du second matériau conducteur.

6. Dispositif d'affichage selon la revendication 5, dans lequel une section de la ligne de commande est formée à partir d'un même matériau qu'une électrode de grille d'un transistor dans le pixel.

7. Dispositif d'affichage selon la revendication 2, dans lequel :
les premier et second inverseurs comportent chacun des transistors de types de conductivité différents qui sont couplés en série entre une première source de puissance et une seconde source de puissance, les premier et second inverseurs étant couplés l'un à l'autre, la première section de la ligne de commande est couplées à des électrodes de grille de transistors dans le premier inverseur ;
la seconde section de la ligne de commande est couplée à des électrodes de source/drain de transistors dans le second inverseur ; et
les première et seconde sections de la ligne de commande sont couplées électriquement au moyen du circuit tampon (12).

8. Dispositif d'affichage selon l'une quelconque des revendications précédentes, dans lequel :
l'unité de pixels (10) inclut une première ligne de puissance qui est configurée de manière à appliquer la première source de puissance sur les circuits tampon (12) ;
l'unité de pixels (10) inclut une seconde ligne de puissance qui est configurée de manière à appliquer la seconde source de puissance sur les circuits tampon (12) ; et
l'agencement des premières et secondes lignes de puissance est tel qu'un motif de configuration des premières lignes de puissance est alterné avec un motif de configuration des secondes lignes de puissance ou l'agencement des premières et secondes lignes de puissance est tel que les premières et secondes lignes de puissance sont disposées selon un maillage dans l'unité de pixels (10).
